# EUROPEAN PATENT APPLICATION

(11) **EP 4 852 630 A1**
(43) Date of publication of application: **09.12.2026**
(21) Application number: 25205985.2
(22) Date of filing: 01.10.2025
(51) Int. Cl.: H05K 5/02

(54) **ELECTRONIC DEVICE**

(30) Priority: 04.06.2025 KR 20250073028
(71) Applicant: Hyundai Mobis Co., Ltd., Gangnam-gu Seoul 06141 (KR)
(72) Inventor: PARK, Seong Hyeon, 16891 Yongin-si, Gyeonggi-do (KR); LEE, Hyun Seong, 16891 Yongin-si, Gyeonggi-do (KR); YU, Byung Mo, 16891 Yongin-si, Gyeonggi-do (KR); JEON, Sung Bae, 16891 Yongin-si, Gyeonggi-do (KR); LEE, Kyeong Jun, 16891 Yongin-si, Gyeonggi-do (KR); KIM, In Gun, 16891 Yongin-si, Gyeonggi-do (KR); YOO, Sung Min, 16891 Yongin-si, Gyeonggi-do (KR); LEE, Chang Kwun, 16891 Yongin-si, Gyeonggi-do (KR)
(74) Representative: Jung, Minkyu

(57) **Abstract**

The electronic device includes a housing, a substrate disposed in the housing and configured to allow an electronic element to be mounted thereon, a first cover disposed on the substrate and including a chamber, a heat dissipation plate disposed at a lower side of the chamber and configured to contact the electronic element, a second cover disposed at an upper side of the chamber and coupled to the first cover, and a first drain channel connected to the chamber and configured to discharge water introduced between the first cover and the second cover.

## Description

### BACKGROUND

### TECHNICAL FIELD

Exemplary embodiments of the present disclosure relate to an electronic device, and more particularly, to an electronic device which is installed in a vehicle.

### DISCUSSION OF THE BACKGROUND

Vehicles are provided with various types of electronic control devices for controlling electronic operations of the vehicles. Recently, chipsets with higher power consumption have been applied to such electronic control devices to support various functions and implement high-performance functions. Accordingly, the importance of a heat dissipation system for efficiently dissipating heat generated from the chipsets has been increasingly emphasized.

In conventional electronic control devices, a fan is installed inside or outside the electronic control devices to secure heat dissipation performance. However, in the case where the fan is applied to the outside of the electronic control devices, there is a problem in that the size of a product increases, making it difficult to apply the product in a vehicle where space is limited. In addition, in the case where the fan is applied to the inside of the electronic control devices, there is a problem in that a heat dissipation effect by convection deteriorates due to convection resistance inside the product.

The background art of the present disclosure is disclosed in Korean Patent No. 10-2563739 (registered on Aug. 11, 2023, entitled "ELECTRICAL EQUIPMENT COOLING SYSTEM FOR VEHICLE").

### SUMMARY

Various embodiments are directed to providing an electronic device capable of efficiently discharging water introduced from the outside.

In an embodiment, an electronic device may include: a housing; a substrate disposed in the housing and configured to allow an electronic element to be mounted thereon; a first cover disposed on the substrate and including a chamber; a heat dissipation plate disposed at a lower side of the chamber and configured to contact the electronic element; a second cover disposed at an upper side of the chamber and coupled to the first cover; and a first drain channel connected to the chamber and configured to discharge water introduced between the first cover and the second cover.

The first cover may include: a bottom plate disposed at the lower side of the chamber and connected to the heat dissipation plate; a first inner wall extending upward from the bottom plate and disposed to enclose a perimeter of the chamber; a support surface disposed on an upper side of the first inner wall and configured to contact a lower surface of the second cover; and a second inner wall extending upward from the support surface and disposed to face a peripheral surface of the second cover. The first drain channel may include: a discharge channel passing through the first inner wall and connected to the chamber; and a transfer channel recessed from the support surface and connected to the chamber.

The transfer channel may be disposed to face a space between the second inner wall and the peripheral surface of the second cover.

The first inner wall may include: a first end wall; a second end wall disposed to be spaced apart from the first end wall in a first direction; and a pair of side walls disposed between the first end wall and the second end wall and arranged to face each other in a second direction intersecting the first direction. The discharge channel may pass through the second end wall in the first direction.

An upper surface of the bottom plate may be formed to be inclined downward along the first direction.

A thickness of the bottom plate may decrease along the first direction.

An inclination angle of the upper surface of the bottom plate with respect to the first direction may range from 1° to 5°.

The support surface may include: a first support surface disposed on an upper side of the first end wall; and a second support surface connected to the first support surface and disposed on an upper side of each of the pair of side walls. The transfer channel may include: a first transfer channel recessed from the first support surface; and a second transfer channel extending from an end of the first transfer channel and recessed from the second support surface.

An end of the second transfer channel may pass through the side wall and be connected to the chamber.

The electronic device may further include: a cooling fan coupled to the housing and configured to introduce external air of the housing into the housing; and a convection hole passing through the first end wall in the first direction and disposed to face the cooling fan.

A surface roughness of the first support surface may be lower than a surface roughness of the second support surface.

The surface roughness of the first support surface may be equal to or greater than 0.1 µm and equal to or less than 1 µm.

The electronic device may further include a pair of partition walls extending from the first end wall in the first direction and disposed to face respective ones of the side walls in the second direction.

Each of the pair of partition walls may include a first end and a second end spaced apart from each other in the first direction. The first end of the partition wall may be connected to the first end wall. The second end of the partition wall may be disposed to be spaced apart from the second end wall.

The electronic device may further include a plurality of heat dissipation fins extending from the heat dissipation plate toward the second cover and disposed in the chamber.

The plurality of heat dissipation fins may be disposed parallel to the first direction and arranged along the second direction.

The electronic device may further include a thermal conduction pad disposed between the heat dissipation fins and the second cover.

An area of the thermal conduction pad may be smaller than an area of each of the heat dissipating plate and the second cover.

The electronic device may further include a second drain channel spaced apart from the chamber and recessed from an upper surface of the first cover.

The second drain channel may be connected to the first drain channel.

According to the present disclosure, water introduced into the housing may be smoothly discharged, thereby preventing damage to a substrate or an electronic element due to the water.

According to the present disclosure, the electronic element may be effectively cooled through conduction by a heat dissipation plate.

According to the present disclosure, heat dissipation performance may be further improved through a first cover and a second cover that are thermally connected to the heat dissipation plate.

According to the present disclosure, the electronic element may be more effectively cooled not only by conduction through contact between components but also by convection through airflow.

According to the present disclosure, water may be prevented from entering a convection passage of air used for heat dissipation.

### BRIEF DESCRIPTION OF THE DRAWINGS

FIG. 1 is a perspective view schematically illustrating a configuration of an electronic device according to an embodiment of the present disclosure.
FIG. 2 is an exploded perspective view schematically illustrating the configuration of the electronic device according to an embodiment of the present disclosure.
FIG. 3 is an exploded perspective view illustrating the configuration of the electronic device according to an embodiment of the present disclosure from a viewpoint different from that of FIG. 2.
FIG. 4 is a sectional view taken along line A-A' of FIG. 1.
FIG. 5 is a perspective view schematically illustrating configurations of a first cover, a heat dissipation plate, and a second cover according to an embodiment of the present disclosure.
FIG. 6 is an exploded perspective view schematically illustrating the configurations of the first cover, the heat dissipation plate, and the second cover according to an embodiment of the present disclosure.
FIG. 7 is a plan view schematically illustrating the configurations of the first cover, the heat dissipation plate, and the second cover according to an embodiment of the present disclosure.
FIG. 8 is a sectional view taken along line B-B' of FIG. 5.
FIG. 9 is a sectional view taken along line C-C' of FIG. 5.
FIG. 10 is an enlarged view schematically illustrating the configuration of the first cover according to an embodiment of the present disclosure.
FIG. 11 is a perspective view schematically illustrating a configuration of a first transfer channel according to an embodiment of the present disclosure.
FIG. 12 is a sectional view schematically illustrating the configuration of the first transfer channel according to an embodiment of the present disclosure.
FIG. 13 is a perspective view schematically illustrating a configuration of a second transfer channel according to an embodiment of the present disclosure.
FIG. 14 is a sectional view schematically illustrating the configuration of the second transfer channel according to an embodiment of the present disclosure.
FIG. 15 is a diagram schematically illustrating a shape of a contact region between a first support surface and the second cover according to an embodiment of the present disclosure.
FIG. 16 is a diagram schematically illustrating a shape of a contact region between a second support surface and the second cover according to an embodiment of the present disclosure.
FIGS. 17 to 19 are diagrams schematically illustrating a water discharge operation of the electronic device according to an embodiment of the present disclosure.

### DETAILED DESCRIPTION OF THE ILLUSTRATED EMBODIMENTS

Hereinafter, embodiments of the present disclosure will be described with reference to the accompanying drawings.

It should be noted that the drawings are not to precise scale and may be exaggerated in thickness of lines or sizes of components for descriptive convenience and clarity only. Furthermore, the terms as used herein are defined by taking functions of the present disclosure into account and can be changed according to the custom or intention of users or operators. Therefore, definition of the terms should be made according to the overall disclosures set forth herein.

Throughout the specification, when one element is referred to as being "connected (or coupled) to" another element, it may not only indicate that the former element is "directly connected (or coupled) to" the latter element, but also indicate that the former element is "indirectly connected (or coupled) to" the latter element with another element interposed therebetween. Furthermore, when an element is referred to as "including (or having)" a component, it may indicate that the element does not exclude another component unless otherwise defined, but can further "include (or have)" another component.

Throughout the present specification, the same reference numerals may refer to the same components. Even though the same or similar reference numerals are not mentioned or described in a specific drawing, such reference numerals may be described based on other drawings. Furthermore, even though certain portions are not indicated by reference numerals in a specific drawing, the portions may be described based on other drawings. In addition, the number, shape, and size of detailed components included in the drawings of the present application and relative differences in size are set for convenience of understanding, and do not limit embodiments, which may be implemented in various forms.

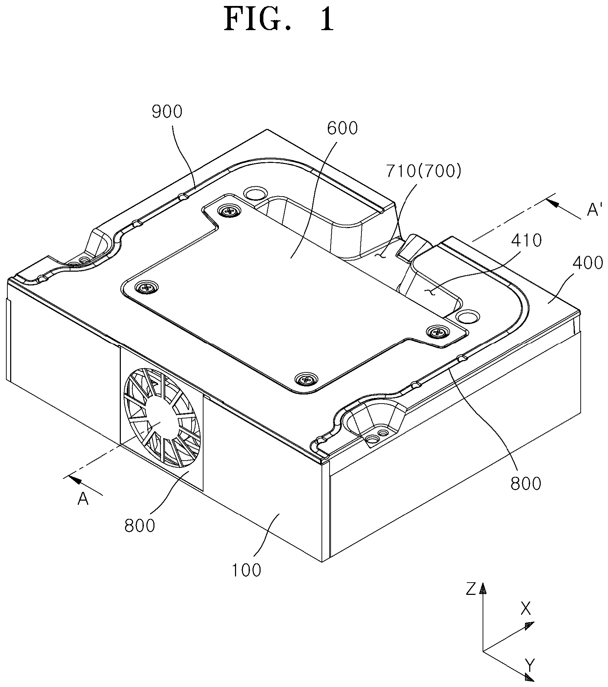

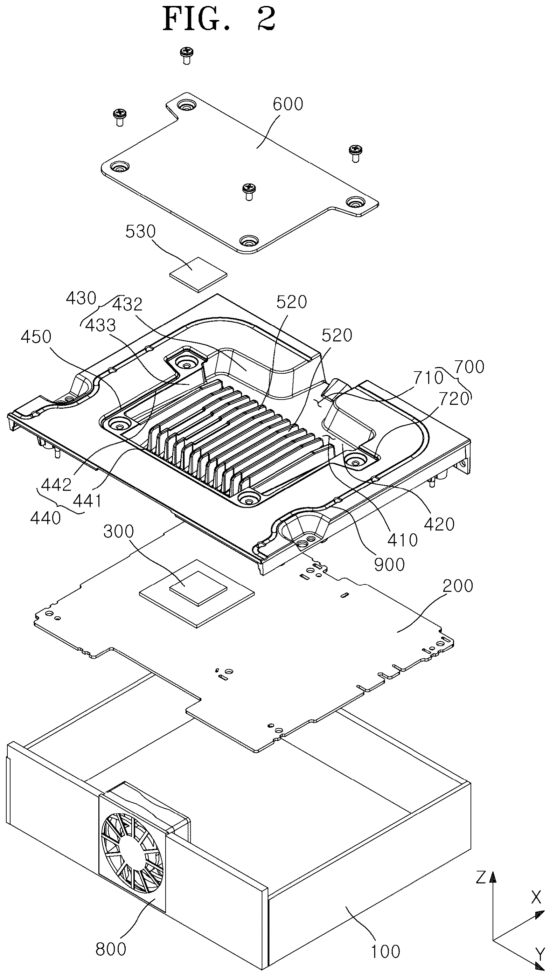

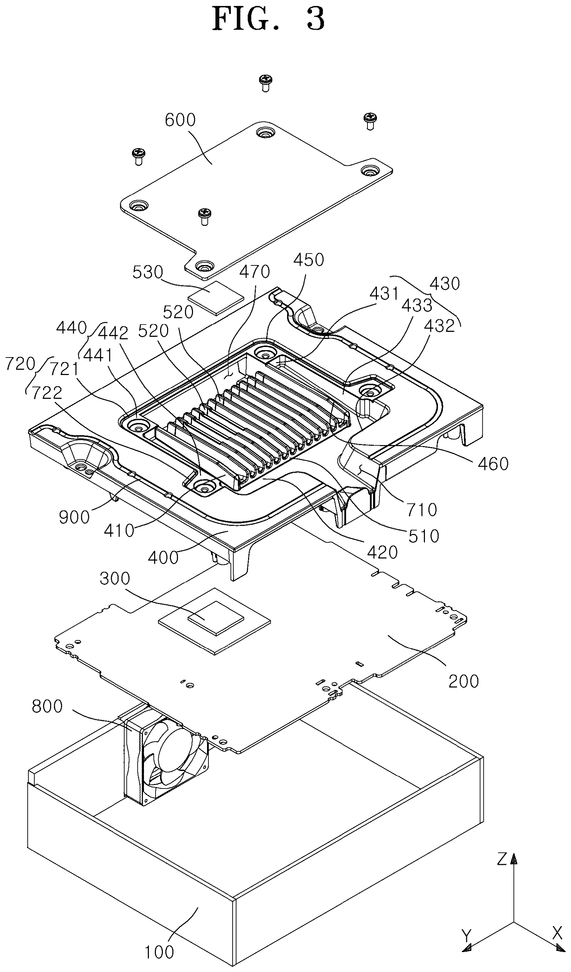

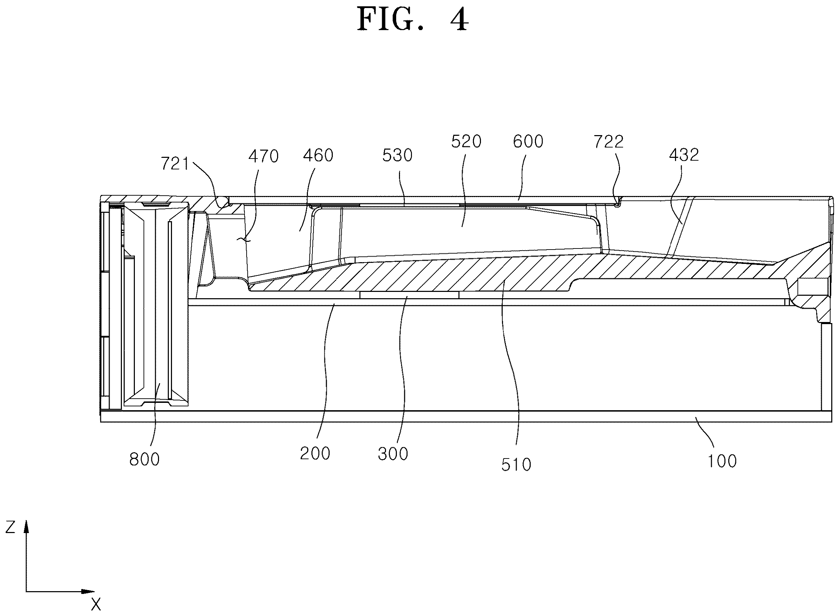

FIG. 1 is a perspective view schematically illustrating a configuration of an electronic device according to an embodiment of the present disclosure. FIG. 2 is an exploded perspective view schematically illustrating the configuration of the electronic device according to an embodiment of the present disclosure. FIG. 3 is an exploded perspective view illustrating the configuration of the electronic device according to an embodiment of the present disclosure from a viewpoint different from that of FIG. 2. FIG. 4 is a sectional view taken along line A-A' of FIG. 1.

Referring to FIGS. 1 to 4, the electronic device according to the present embodiment includes a housing 100, a substrate 200, an electronic element 300, a first cover 400, a heat dissipation plate 510, a second cover 600, and a first drain channel 700.

The housing 100 may form substantially an external shape of the electronic device and may accommodate the substrate 200 and the electronic component 300, which are described below. The housing 100 may be formed in a box shape having an open top and a hollow interior. The housing 100 may be formed of a metallic material such as aluminum or steel, which provides sufficient rigidity and high thermal conductivity. The housing 100 may be installed in various interior spaces of a vehicle, such as a cockpit of the vehicle. The housing 100 may be secured in the interior space of the vehicle via various fasteners such as a separate bracket (not shown).

The substrate 200 may be disposed inside the housing 100. The substrate 200 may be a printed circuit board (PCB) having a substantially flat plate shape. The substrate 200 may be disposed such that an upper surface and a lower surface thereof respectively face an open top surface and a bottom surface of the housing 100. The substrate 200 may be secured inside the housing 100 by various types of fasteners such as brackets or bolts.

The electronic element 300 may be mounted on the substrate 200. The electronic element 300 may be mechanically and electrically connected to the substrate 200 by soldering or the like. The electronic element 300 may include at least one of elements or components, such as an active element, a passive element, an integrated circuit (IC) chip, a central processing unit (CPU), a graphics processing unit (GPU), and a power supply, which are mounted on the substrate 200 and perform various electronic functions of the electronic device. The electronic element 300 may generate heat due to intrinsic resistance or the like during the performance of electronic functions of the electronic device.

The first cover 400 may be disposed on the substrate 200 and may cover the open side of the housing 100.

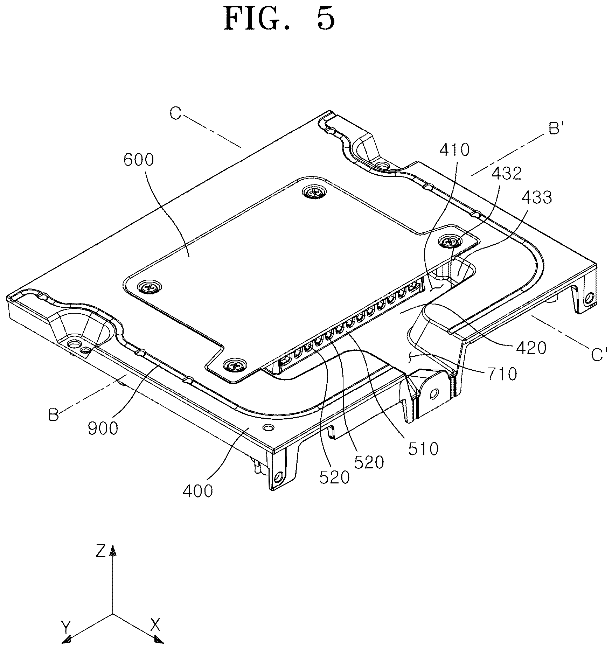

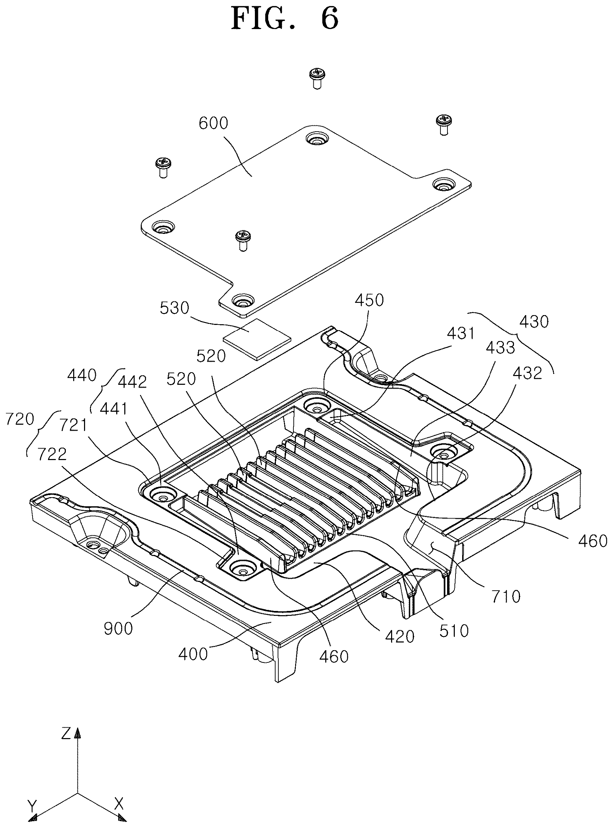

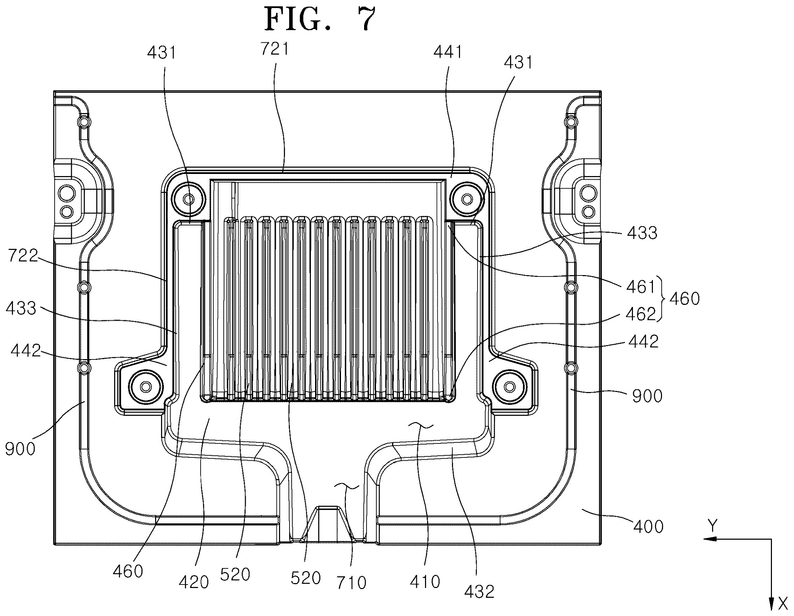

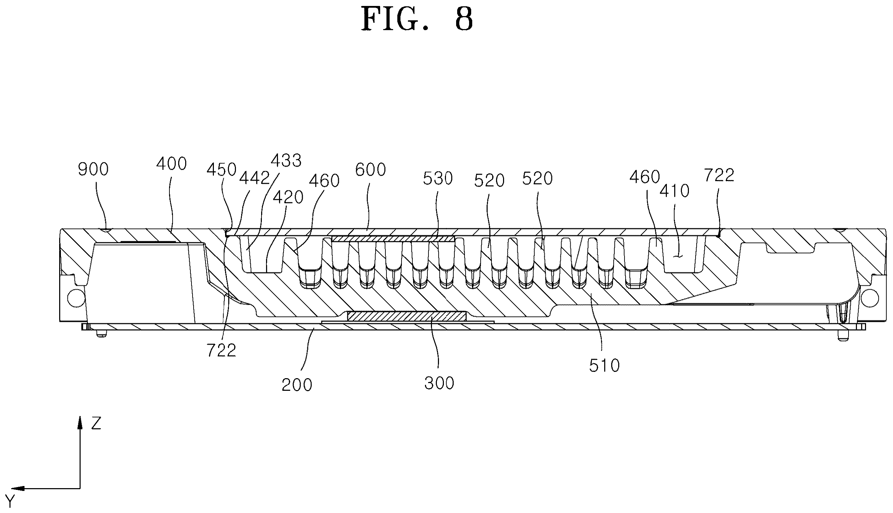

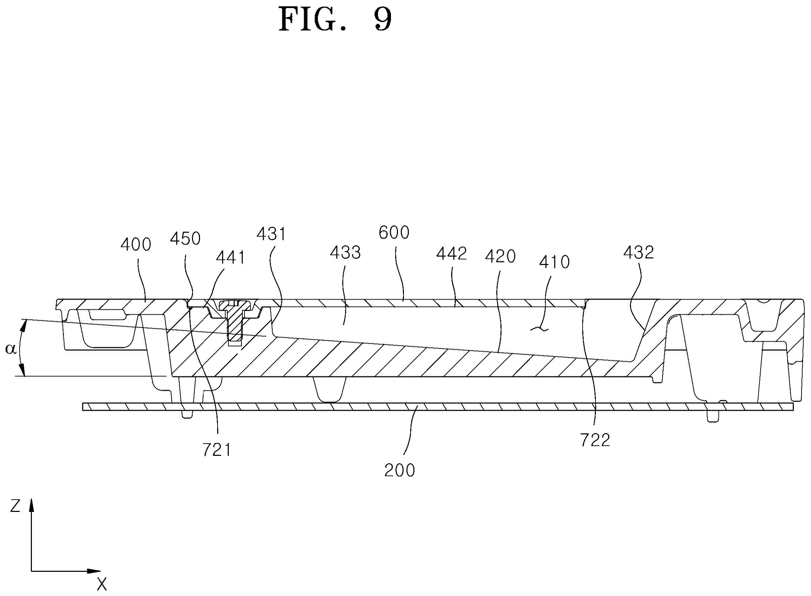

FIG. 5 is a perspective view schematically illustrating configurations of the first cover 400, the heat dissipation plate 510, and the second cover 600 according to an embodiment of the present disclosure. FIG. 6 is an exploded perspective view schematically illustrating the configurations of the first cover 400, the heat dissipation plate 510, and the second cover 600 according to an embodiment of the present disclosure. FIG. 7 is a plan view schematically illustrating the configurations of the first cover 400, the heat dissipation plate 510, and the second cover 600 according to an embodiment of the present disclosure. FIG. 8 is a sectional view taken along line B-B' of FIG. 5. FIG. 9 is a sectional view taken along line C-C' of FIG. 5.

Referring to FIGS. 1 to 9, the first cover 400 according to the present embodiment may have a plate shape covering an upper end of the housing 100. An upper surface of the first cover 400 may be disposed to face a space above the housing 100. A lower surface of the first cover 400 may be disposed to vertically face an upper surface of the substrate 200. The lower surface of the first cover 400 may be disposed to be spaced apart from the upper surface of the substrate 200. An edge of the lower surface of the first cover 400 may be seated on the upper end of the housing 100. The first cover 400 may be secured to the housing 100 by various types of coupling methods such as welding, bolting, or fitting.

The first cover 400 may include a chamber 410, a bottom plate 420, a first inner wall 430, a support surface 440, and a second inner wall 450.

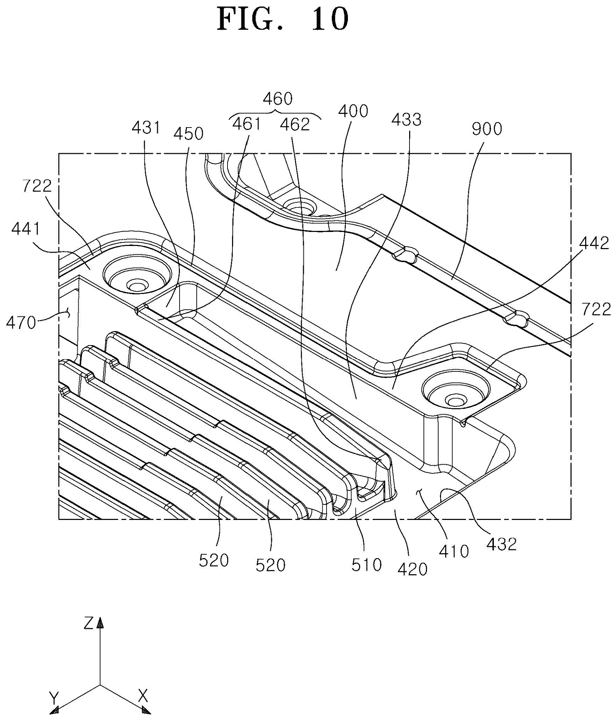

FIG. 10 is an enlarged view schematically illustrating the configuration of the first cover 400 according to an embodiment of the present disclosure.

Referring to FIGS. 1 to 10, the chamber 410 according to the present embodiment may be disposed inside the first cover 400. For example, the chamber 410 may be an internal space of the first cover 400 enclosed by the bottom plate 420, the first inner wall 430, the support surface 440, and the second inner wall 450. An upper end of the chamber 410 may pass through the upper surface of the first cover 400 and communicate with an external space of the first cover 400.

The bottom plate 420 may be disposed at a lower side of the chamber 410. The bottom plate 420 may partition a lower end of the chamber 410 from an internal space of the housing 100.

The bottom plate 420 according to the present embodiment may have a plate shape and be disposed above the substrate 200. The area of the bottom plate 420 may be smaller than that of the first cover 400. A lower surface of the bottom plate 420 may be spaced upward from the substrate 200 by a predetermined distance. An upper surface of the bottom plate 420 may be located lower than the upper surface of the first cover 400. In other words, a distance from the substrate 200 to the upper surface of the bottom plate 420 may be smaller than a distance from the substrate 200 to the upper surface of the first cover 400. The upper surface of the bottom plate 420 may be disposed to face the lower end of the chamber 410. The upper surface of the bottom plate 420 may form a bottom surface of the chamber 410 together with an upper surface of the heat dissipation plate 510, which will be described below.

The first inner wall 430 may extend upward from the bottom plate 420. The first inner wall 430 may be disposed to enclose a lower perimeter of the chamber 410. The first inner wall 430 may partition the lower perimeter of the chamber 410, which is located on the bottom plate 420, from the internal space of the housing 100. In other words, the first inner wall 430 may form a lower peripheral surface of the chamber 410 located on the bottom plate 420.

The first inner wall 430 according to the present embodiment may include a first end wall 431, a second end wall 432, and a side wall 433.

The first end wall 431 and the second end wall 432 may extend upward from the upper surface of the bottom plate 420. The first end wall 431 and the second end wall 432 may be disposed to intersect the bottom plate 420.

The first end wall 431 and the second end wall 432 may be disposed to face each other in a first direction. The second end wall 432 may be spaced apart from the first end wall 431 by a predetermined distance in the first direction. For example, the first end wall 431 and the second end wall 432 may be portions of the first inner wall 430 that are disposed to face each other in the first direction. The first and second directions described below may be directions that are perpendicular to the vertical direction and intersect each other. For example, the first direction may correspond to an X-axis direction, based on FIGS. 1 to 10, and the second direction may correspond to a Y-axis direction, based on FIGS. 1 to 10.

The first end wall 431 and the second end wall 432 may be disposed to intersect the first direction. Longitudinal directions of the first end wall 431 and the second end wall 432 may be oriented parallel to the second direction. The shapes of the first end wall 431 and the second end wall 432 are not limited to those illustrated in the drawings, and may have various shapes, such as a planar shape perpendicular to the first direction, an inclined surface or a curved surface inclined with respect to the first direction, as long as the first end wall 431 and the second end wall 432 intersect the first direction.

The side wall 433 may be located between the first end wall 431 and the second end wall 432. For example, the side wall 433 may correspond to a remaining region of the first inner wall 430 excluding the first end wall 431 and the second end wall 432. The side wall 433 may be provided as a pair. The pair of side walls 433 may be disposed to face each other in a second direction.

The side walls 433 may extend upward from the upper surface of the bottom plate 420. The side walls 433 may be disposed to intersect the bottom plate 420.

The side walls 433 may be disposed to intersect the second direction. The shapes of the side walls 433 are not limited to those illustrated in the drawings, and the side walls 433 may have various shapes, such as a planar shape perpendicular to the second direction, an inclined surface or a curved surface inclined with respect to the second direction, as long as the side walls 433 intersect the second direction.

A longitudinal direction of each of the side walls 433 may be disposed parallel to the first direction. Opposite ends of each of the side walls 433 may be connected to the first end wall 431 and the second end wall 432, respectively. One ends of the different side walls 433 may be connected to opposite ends of the first end wall 431 spaced apart in the second direction, respectively. Remaining ends of the different side walls 433 may be connected to opposite ends of the second end wall 432 spaced apart in the second direction, respectively.

The support surface 440 may be disposed on an upper side of the first inner wall 430. The support surface 440 may function as a configuration that supports the second cover 600, which will be described below, with respect to the first cover 400. The support surface 440 may be disposed at a position lower than the upper surface of the first cover 400.

The support surface 440 according to the present embodiment may include a first support surface 441 and a second support surface 442.

The first support surface 441 may be disposed on an upper side the first end wall 431. The first support surface 441 may extend from an upper end of the first end wall 431 in a direction away from the second end wall 432. The first support surface 441 may have a horizontal planar shape perpendicular to the vertical direction. A longitudinal direction of the first support surface 441 may be oriented parallel to the second direction.

The second support surface 442 may be disposed on an upper side of the side wall 433. The second support surface 442 may be provided as a pair. Each of the second support surfaces 442 may be individually disposed on the upper side of a corresponding one of the different side walls 433. The pair of second support surfaces 442 may extend from upper ends of the respective side walls 433 in directions away from each other.

Each of the second support surfaces 442 may have a horizontal planar shape perpendicular to the vertical direction. A longitudinal direction of the second support surface 442 may be oriented parallel to the first direction. One end of the second support surface 442 may be connected to the first support surface 441. One ends of the respective second support surfaces 442 may be connected to opposite ends of the first support surface 441, respectively. Remaining ends of the second support surfaces 442 may be spaced apart from the second end wall 432 by a predetermined distance in a direction opposite to the first direction.

The second inner wall 450 may extend upward from the support surface 440. The second inner wall 450 may be disposed to enclose an upper perimeter of the chamber 410. The second inner wall 450 may partition the upper perimeter of the chamber 410 from the internal space of the housing 100. In other words, the second inner wall 450 may form an upper peripheral surface of the chamber 410 disposed on the support surface 440.

The second inner wall 450 may extend upward from an outer edge of the support surface 440, which is spaced apart from the first inner wall 430, that is, from outer edges of the first support surface 441 and the second support surface 442. An upper end of the second inner wall 450 may be connected to the upper surface of the first cover 400.

The second inner wall 450 may be disposed to intersect the support surface 440. For example, the second inner wall 450 may be in the form of a vertical plane perpendicular to the support surface 440, or may be in the form of an inclined surface extending upward from the support surface 440.

The second inner wall 450 may extend along the outer edge of the support surface 440. The shape in which the second inner wall 450 extends is not limited to the example illustrated in the drawings, and may be modified in design into various shapes depending on the shape of the support surface 440 or the like.

The heat dissipation plate 510 may function as a configuration that cools the electronic element 300 by absorbing heat generated from the electronic element 300 and dissipating the absorbed heat to the outside. The heat dissipation plate 510 may be in contact with the electronic element 300 and may receive heat from the electronic element 300 through conduction. The heat dissipation plate 510 may be formed of a material having high heat capacity and high thermal conductivity, such as aluminum.

The heat dissipation plate 510 according to the present embodiment may be disposed on the substrate 200. A lower surface of the heat dissipation plate 510 may be in contact with an upper surface of the electronic element 300. The area of the heat dissipation plate 510 may be larger than that of the electronic element 300.

The heat dissipation plate 510 may be disposed at the lower side of the chamber 410. The heat dissipation plate 510 may be connected to the bottom plate 420 and may be supported inside the housing 100 by the bottom plate 420. The heat dissipation plate 510 may form the bottom surface of the chamber 410 together with the bottom plate 420.

In the present embodiment, the heat dissipation plate 510 may be disposed at a central portion of the bottom plate 420. The bottom plate 420 may be disposed to enclose an entire peripheral surface of the heat dissipation plate 510 that is in contact with the electronic element 300. The heat dissipation plate 510 may be integrally formed with the bottom plate 420, or may be separately manufactured from the bottom plate 420 and then coupled to the bottom plate 420.

In the present embodiment, the first cover 400 may be formed of the same material as the heat dissipation plate 510. For example, the first cover 400 may be formed of a material having high heat capacity and high thermal conductivity, such as aluminum. Accordingly, the first cover 400, together with the heat dissipation plate 510, may perform an operation of dissipating heat generated from the electronic element 300, thereby further improving the efficiency with which the electronic element 300 is cooled.

An upper end of the heat dissipation plate 510 may protrude upward from the bottom plate 420, and may also be formed to define a continuous plane with the upper surface of the bottom plate 420.

The second cover 600 may be disposed on an upper side of the chamber 410 and may be coupled to the first cover 400. The second cover 600 may function as a configuration that covers an open side of the chamber 410, that is, an upper end of the chamber 410.

The second cover 600 according to the present embodiment may have a flat plate shape perpendicular to the vertical direction. The second cover 600 may be disposed on the upper side of the chamber 410. A lower surface of the second cover 600 may be in contact with the support surface 440. A portion of the lower surface of the second cover 600 may be in contact with the first support surface 441, and another portion of the lower surface of the second cover 600 may be in contact with the second support surface 442.

A peripheral surface of the second cover 600 may be disposed to face the second inner wall 450. That is, the second inner wall 450 may be disposed to enclose the entire peripheral surface of the second cover 600. Accordingly, the second cover 600 may be positioned in place on the support surface 440 without being displaced in a horizontal direction.

The second cover 600 may be secured to the first cover 400 by a bolt or the like that vertically passes through the second cover 600 and the support surface 440.

A cross-sectional area of the second cover 600 may be smaller than that of the chamber 410. A portion of the peripheral surface of the second cover 600, which is oriented in the first direction, may be spaced apart from the second end wall 432 by a predetermined distance. Accordingly, a partial region of the upper end of the chamber 410 located between the second cover 600 and the second end wall 432 may be formed to be open.

The second cover 600 may be formed of the same material as the heat dissipation plate 510 and the first cover 400. For example, the second cover 600 may be formed of a material having high heat capacity and high thermal conductivity, such as aluminum. Accordingly, the second cover 600, together with the heat dissipation plate 510 and the first cover 400, may perform an operation of dissipating heat generated from the electronic element 300, thereby further improving the efficiency with which the electronic element 300 is cooled.

The first drain channel 700 may be connected to the chamber 410 and may discharge water that enters between the first cover 400 and the second cover 600, to the outside of the housing 100. Accordingly, the first drain channel 700 may prevent water introduced through a gap between the first cover 400 and the second cover 600 from being accumulated inside the chamber 410 or flowing toward the substrate 200.

The first drain channel 700 according to the present embodiment may include a discharge channel 710 and a transfer channel 720.

The discharge channel 710 may pass through the first inner wall 430 and may be connected to the chamber 410. The discharge channel 710 may function as a structure that discharges water introduced into the chamber 410 to the outside of the housing 100.

The discharge channel 710 according to the present embodiment may have a hole shape that passes through the second end wall 432 in the first direction. A first end of the discharge channel 710 may passes through the second end wall 432 and communicate with an internal space of the chamber 410. A second end of the discharge channel 710 may pass through a peripheral surface of the first cover 400 and may communicate with an external space of the housing 100. Accordingly, water introduced into the chamber 410 may be discharged to the outside of the housing 100 in the first direction through the discharge channel 710.

In the present embodiment, the upper surface of the bottom plate 420 may be inclined downward along the first direction. As the lower surface of the bottom plate 420 is in the form of a horizontal plane perpendicular to the first direction for contact with the electronic element 300, a thickness of the bottom plate 420 may gradually decrease along the first direction. Accordingly, water introduced into the chamber 410 may flow in the first direction by an inclination angle of the bottom plate 420, without a separate power device, and may be transferred to the discharge channel 710.

An inclination angle α of the upper surface of the bottom plate 420 with respect to the first direction may range from 1° to 5°. The inclination angle α of the upper surface of the bottom plate 420 with respect to the first direction may be equal to an inclination angle of the upper surface of the bottom plate 420 with respect to the lower surface of the bottom plate 420.

In the case where the inclination angle α of the upper surface of the bottom plate 420 with respect to the first direction is less than 1°, water introduced into the chamber 410 may not be smoothly transferred to the discharge channel 710.

In the case where the inclination angle α of the upper surface of the bottom plate 420 with respect to the first direction is greater than 5°, a thickness deviation of the bottom plate 420 by region may excessively increase, resulting in an increase in fabrication difficulty and a degradation in cooling performance for the electronic element 300.

The transfer channel 720 may be recessed from the support surface 440 and may be connected to the chamber 410. The transfer channel 720 may function as a configuration that transfers water, which is introduced through the gap between the first cover 400 and the second cover 600, to the internal space of the chamber 410.

The transfer channel 720 may have a tubular shape having a relatively small diameter compared to an extension length. Accordingly, the transfer channel 720 may transfer water, which enters between the peripheral surface of the first cover 400 and the second inner wall 450, to the chamber 410 through capillary action without a separate power device.

As the first cover 400 and the second cover 600 are formed as separate components, a space with a constant width may be formed between the second inner wall 450 of the first cover 400 and the peripheral surface of the second cover 600.

The transfer channel 720 may be disposed to vertically face the space between the second inner wall 450 and the peripheral surface of the second cover 600. Accordingly, water introduced through a gap between the first cover 400 and the second cover 600 may more rapidly flow into the transfer channel 720.

The transfer channel 720 according to the present embodiment may include a first transfer channel 721 and a second transfer channel 722.

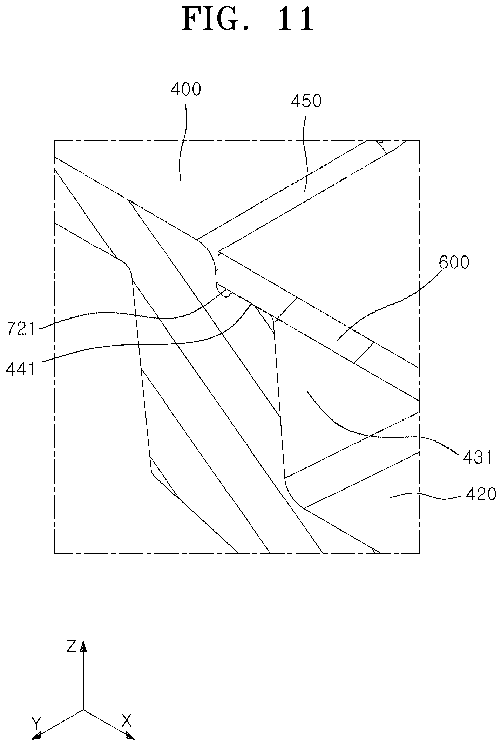

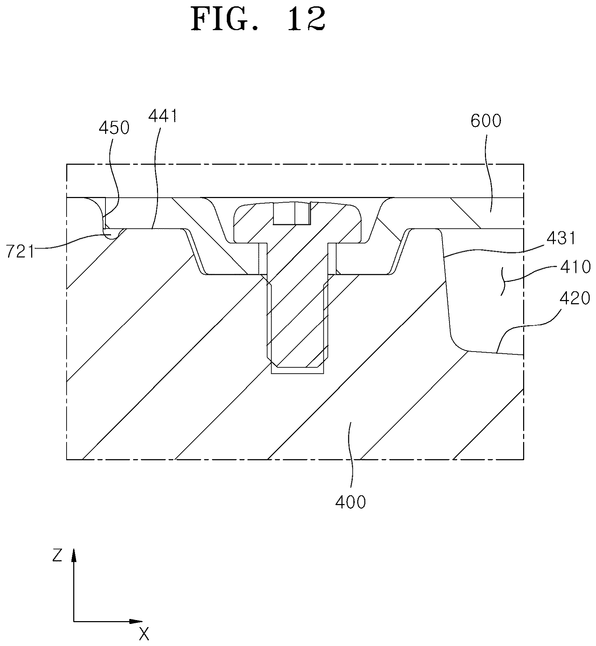

FIG. 11 is a perspective view schematically illustrating the configuration of the first transfer channel 721 according to an embodiment of the present disclosure. FIG. 12 is a sectional view schematically illustrating the configuration of the first transfer channel 721 according to an embodiment of the present disclosure.

Referring to FIGS. 5 to 12, the first transfer channel 721 according to the present embodiment may have a groove shape recessed downward from the first support surface 441. A cross-sectional shape of the first transfer channel 721 may have a semicircular shape with an open top. In addition to the semicircular shape shown in FIG. 11, the cross-sectional shape of the first transfer channel 721 may also be modified in design into various shapes such as polygons or ellipses.

The first transfer channel 721 may be disposed in an outer edge region of the first support surface 441 adjacent to the second inner wall 450. The first transfer channel 721 may extend along a boundary region between the first support surface 441 and the second inner wall 450. Accordingly, a partial region of an upper end of the first transfer channel 721 may be disposed to vertically face the space between the second inner wall 450 and the peripheral surface of the second cover 600.

Opposite ends of the first transfer channel 721 may be spaced apart from each other in the second direction.

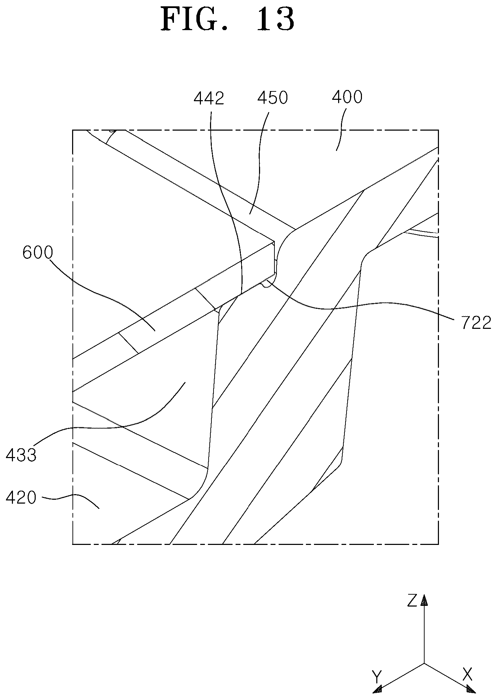

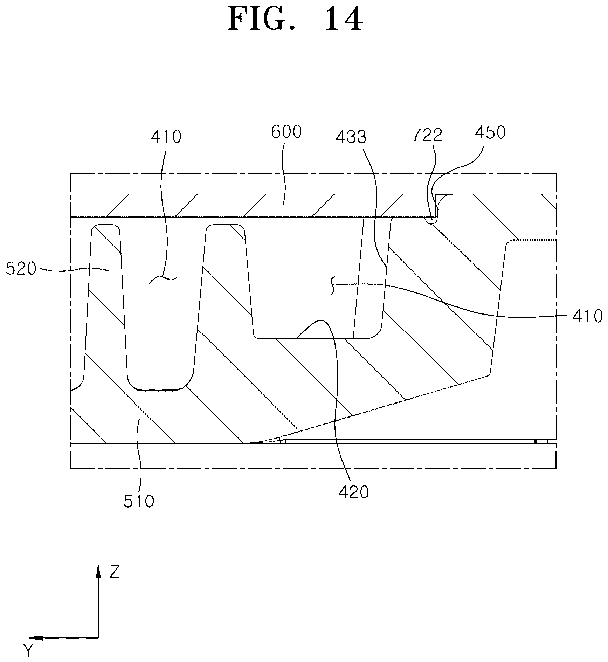

FIG. 13 is a perspective view schematically illustrating a configuration of the second transfer channel 722 according to an embodiment of the present disclosure. FIG. 14 is a sectional view schematically illustrating the configuration of the second transfer channel 722 according to an embodiment of the present disclosure

Referring to FIGS. 5 to 10, 13, and 14, the second transfer channel 722 according to the present embodiment may have a groove shape recessed downward from the second support surface 442. A cross-sectional shape of the second transfer channel 722 may have a semicircular shape with an open top. In addition to the semicircular shape shown in FIG. 13, the cross-sectional shape of the second transfer channel 722 may also be modified in design into various shapes such as polygons or ellipses.

The second transfer channel 722 may be disposed in an outer edge region of the second support surface 442 adjacent to the second inner wall 450. The second transfer channel 722 may extend along a boundary region between the second support surface 442 and the second inner wall 450. Accordingly, a partial region of an upper end of the second transfer channel 722 may be disposed to vertically face the space between the second inner wall 450 and the peripheral surface of the second cover 600.

The second transfer channel 722 may be provided as a pair. The pair of second transfer channels 722 may be individually formed on the different second support surfaces 442. The pair of second transfer channels 722 may be symmetrically disposed on the respective different second support surfaces 442.

A first end of each of the second transfer channels 722 may be disposed to face a direction opposite to the first direction. The first end of each of the second transfer channels 722 disposed to face the direction opposite to the first direction may be connected to the first transfer channel 721. The respective first ends of the different second transfer channels 722 may be connected to opposite ends of the first transfer channel 721.

A second end of each of the second transfer channels 722 may pass through the side wall 433 and may communicate with the internal space of the chamber 410. Accordingly, water introduced into the first transfer channel 721 or the second transfer channels 722 through the gap between the second inner wall 450 and the peripheral surface of the second cover 600 may be transferred to the chamber 410 through the second ends of the second transfer channels 722. The respective second ends of the different second transfer channels 722 may individually pass through the corresponding side walls 433.

The electronic device according to the present embodiment may further include a heat dissipation fin 520.

The heat dissipation fin 520 may extend from the heat dissipation plate 510 toward the second cover 600.

The heat dissipation fin 520 according to the present embodiment may extend upward from the upper surface of the heat dissipation plate 510. The heat dissipation fin 520 may be in the form of a plate that is disposed parallel to the first direction and has opposite surfaces perpendicular to the second direction. An upper end of the heat dissipation fin 520 may be spaced apart from the lower surface of the second cover 600, or may be in direct contact with the lower surface of the second cover 600.

A plurality of heat dissipation fins 520 may be provided. The plurality of heat dissipation fins 520 may be arranged along the second direction between the pair of side walls 433. A pair of heat dissipation fins 520 that are positioned at outermost sides among the plurality of heat dissipation fins 520 arranged along the second direction may be disposed to be spaced apart from the side walls 433.

The number of heat dissipation fins 520 and spacing between adjacent heat dissipation fins 520 may be variously modified in design depending on factors such as the area of the heat dissipation plate 510.

The electronic device according to the present embodiment may further include a thermal conduction pad 530.

The thermal conduction pad 530 may be disposed between the heat dissipation fins 520 and the second cover 600.

The thermal conduction pad 530 according to the present embodiment may be in the form of a pad or sheet perpendicular to the vertical direction. The thermal conduction pad 530 may include various types of thermal interface materials (TIMs) in which a thermally conductive filler such as aluminum oxide, boron nitride, or graphite is contained in polymer resin such as polypropylene (PP) or polytetrafluoroethylene (PTFE).

A lower surface of the thermal conduction pad 530 may be in contact with the upper ends of the heat dissipation fins 520, and an upper surface of the thermal conduction pad 530 may be in contact with the lower surface of the second cover 600. Accordingly, the thermal conduction pad 530 may increase a contact area between the heat dissipation fins 520 and the second cover 600, thereby further improving heat transfer efficiency between the heat dissipation fins 520 and the second cover 600.

The area of the thermal conduction pad 530 may be smaller than that of each of the heat dissipation plate 510 and the second cover 600. The lower surface of the thermal conduction pad 530 may be in contact only with upper ends of some of the plurality of heat dissipation fins 520.

Although FIGS. 1 to 14 illustrate an example in which the electronic device according to the present embodiment includes the heat dissipation fin 520 and the thermal conduction pad 530, the electronic device according to the present embodiment is not limited thereto, and may be configured without including the heat dissipation fin 520 and the thermal conduction pad 530.

The electronic device according to the present embodiment may further include a cooling fan 800 and a convection hole 470.

The cooling fan 800 may be coupled to the housing 100 and may introduce air from outside the housing 100 into the inside of the housing 100.

According to the present embodiment, the cooling fan 800 may be implemented with various types of blowers configured to be supplied with power from an external source and to cause air from outside the housing 100 to flow into the inside of the housing 100.

The cooling fan 800 may be coupled to a side surface of the housing 100. The cooling fan 800 may be disposed at a position spaced apart from the chamber 410 in a direction opposite to the first direction. The cooling fan 800 may cause air introduced from outside the housing 100 to flow in the first direction inside the housing 100.

The convection hole 470 may function as a configuration that introduces air, which flows inside the housing 100 by the cooling fan 800, into the chamber 410.

According to the present embodiment, the convection hole 470 may pass through the first end wall 431 in the first direction. An end of the convection hole 470 may be oriented to face the cooling fan 800 in the first direction and may communicate with the internal space of the housing 100. A remaining end of the convection hole 470 may be oriented to face the second end wall 432 in the first direction and may be oriented to face the inner space of the chamber 410. Accordingly, air flowing in the first direction inside the housing 100 by the cooling fan 800 may be introduced into the chamber 410 through the convection hole 470. The air introduced into the chamber 410 through the convection hole 470 may be discharged to the outside of the housing 100 through the space between the second cover 600 and the second end wall 432 or through the discharge channel 710. As air supplied by the cooling fan 800 continuously passes through the chamber 410 in the aforementioned manner, the heat dissipation performance of the heat dissipation plate 510, the first cover 400, and the second cover 600 may be further improved by convection.

The convection hole 470 may be oriented to face an end of each heat dissipation fin 520 that is disposed in a direction opposite to the first direction. Accordingly, air introduced into the chamber 410 through the convection hole 470 may pass through spaces between adjacent heat dissipation fins 520, thereby improving the heat dissipation efficiency of the heat dissipation fins 520.

In the present embodiment, as the first cover 400 and the second cover 600 are configured as separate components, a minute gap may be formed between the lower surface of the second cover 600 and the support surface 440 due to factors such as inherent surface roughness of the lower surface of the second cover 600 and the support surface 440.

Accordingly, in the case where an excessive amount of water is introduced between the second inner wall 450 and the peripheral surface of the second cover 600, a portion of the water transferred to the transfer channel 720 may overflow from the transfer channel 720 and enter the gap between the lower surface of the second cover 600 and the support surface 440.

Of the water overflowing from the transfer channel 720, water passing between the lower surface of the second cover 600 and the second support surface 442 may be transferred to the bottom plate 420 by the side wall 433 and may be discharged through the discharge channel 710.

However, of the water overflowing from the transfer channel 720, water passing between the lower surface of the second cover 600 and the first support surface 441 may leak through the convection hole 470 formed in the first end wall 431, and there is a risk that the leaked water may contact the substrate 200 or the electronic element 300.

Given the risk of leakage, the electronic device according to the present embodiment may be configured to significantly reduce the proportion of water introduced between the lower surface of the second cover 600 and the first support surface 441, or to prevent water from being introduced between the lower surface of the second cover 600 and the first support surface 441.

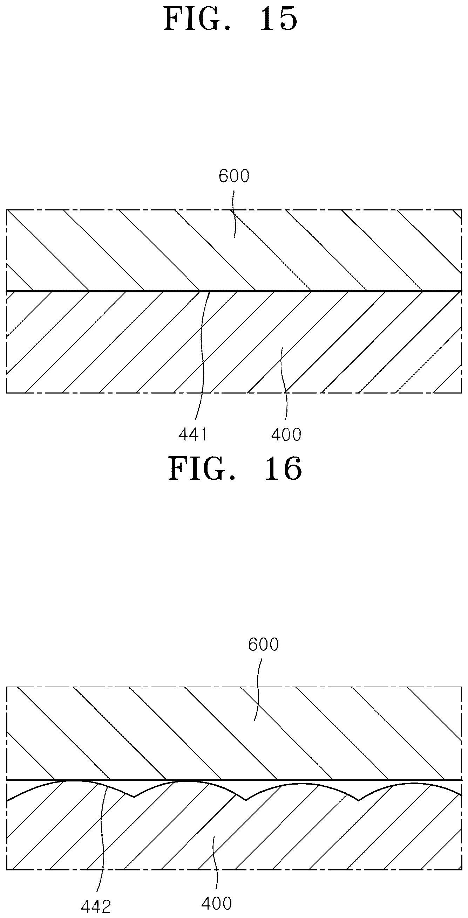

FIG. 15 is a diagram schematically illustrating a shape of a contact region between the first support surface 441 and the second cover 600 according to an embodiment of the present disclosure. FIG. 16 is a diagram schematically illustrating a shape of a contact region between the second support surface 442 and the second cover 600 according to an embodiment of the present disclosure.

Referring to FIGS. 15 and 16, the surface roughness of the first support surface 441 according to the present embodiment may be smaller than the surface roughness of the second support surface 442. For example, the surface roughness described below may be represented by an arithmetic average roughness (Ra).

The first support surface 441 may be formed to have a lower surface roughness than the second support surface 442 through a polishing process using a separate numerical control (NC) machining tool. For example, after the first support surface 441 and the second support surface 442 are formed by a cutting process or the like, a separate polishing process may be performed only on the first support surface 441. Accordingly, as the polishing process is partially performed only on the first support surface 441, for which the introduction of water is to be essentially blocked, process costs may be reduced.

The surface roughness of the first support surface 441 may be equal to or greater than 0.1 µm and equal to or less than 1 µm.

In the case where the surface roughness of the first support surface 441 is less than 0.1 µm, the degree of difficulty in the fabrication process of the first support surface 441 may excessively increase. In the case where the surface roughness of the first support surface 441 exceeds 1 µm, water may be introduced between the lower surface of the second cover 600 and the first support surface 441 due to capillary action or the like.

The surface roughness of the second support surface 442 may be variously modified in design within a range greater than 1 µm.

Accordingly, the lower surface of the second cover 600 may be in further close contact with the first support surface 441 without gaps, so that a proportion of water introduced between the lower surface of the second cover 600 and the first support surface 441 may be significantly reduced, or a passage of water between the lower surface of the second cover 600 and the first support surface 441 may be blocked.

The electronic device according to the present embodiment may further include a partition wall 460.

The partition wall 460 may extend in the first direction from the first end wall 431 toward the second end wall 432.

The partition wall 460 may be provided as a pair. The pair of partition walls 460 may be spaced apart from each other in the second direction. Each of the partition walls 460 may be disposed to be spaced apart from a different one of the side walls 433 by a predetermined distance in the second direction.

The pair of partition walls 460 may be disposed on opposite sides of the convection hole 470. For example, a distance between the pair of partition walls 460 may be greater than a width of the convection hole 470 in the second direction. Accordingly, the partition walls 460 may block water that has passed between the lower surface of the second cover 600 and the second support surface 442 from being introduced into the convection hole 470 through the bottom plate 420.

The pair of partition walls 460 may be disposed on opposite sides of the plurality of heat dissipation fins 520. For example, the plurality of heat dissipation fins 520 may be disposed between the pair of partition walls 460 spaced apart from each other in the second direction.

Each of the partition walls 460 may include a first end 461 and a second end 462 spaced apart from each other in the first direction.

The first end 461 of the partition wall 460 may be disposed to face the direction opposite to the first direction. The first end 461 may be connected to the first end wall 431. The first end 461 may be integrally formed with the first end wall 431, or may be manufactured separately from the first end wall 431 and then coupled to the first end wall 431.

The second end 462 of the partition wall 460 may be disposed to face the first direction. The second end 462 may be spaced apart from the second end wall 432 by a predetermined distance in the first direction. Accordingly, water that has passed between the lower surface of the second cover 600 and the second support surface 442 may be transferred to the discharge channel 710 through space between the second end 462 and the second end wall 432.

The electronic device according to the present embodiment may further include a second drain channel 900.

The second drain channel 900 may discharge, to the outside of the housing 100, water formed on the first cover 400 other than water introduced between the first cover 400 and the second cover 600.

The second drain channel 900 according to the present embodiment may be in the form of a groove recessed downward from the upper surface of the first cover 400. The second drain channel 900 may be spaced apart from the chamber 410.

The second drain channel 900 may extend in the form of a band having at least one linear section and at least one curved section on the first cover 400. The specific shape of the second drain channel 900 is not limited to that illustrated in the drawings and may be modified in design into various shapes.

A first end of the second drain channel 900 may be connected to the first drain channel 700. For example, the first end of the second drain channel 900 may pass through an inner wall of the discharge channel 710 and communicate with an internal space of the discharge channel 710. Alternatively, the first end of the second drain channel 900 may pass through the second end wall 432 and communicate with the inner space of the chamber 410.

A second end of the second drain channel 900 may pass through the peripheral surface of the first cover 400. Therefore, the second drain channel 900 may discharge water on the first cover 400 through the opposite ends thereof.

Accordingly, the first drain channel 700 may prevent water introduced through the gap between the first cover 400 and the second cover 600 from being accumulated in the chamber 410 or from being transferred toward the substrate 200.

Hereinafter, a water discharge operation of the electronic device according to an embodiment of the present disclosure will be described.

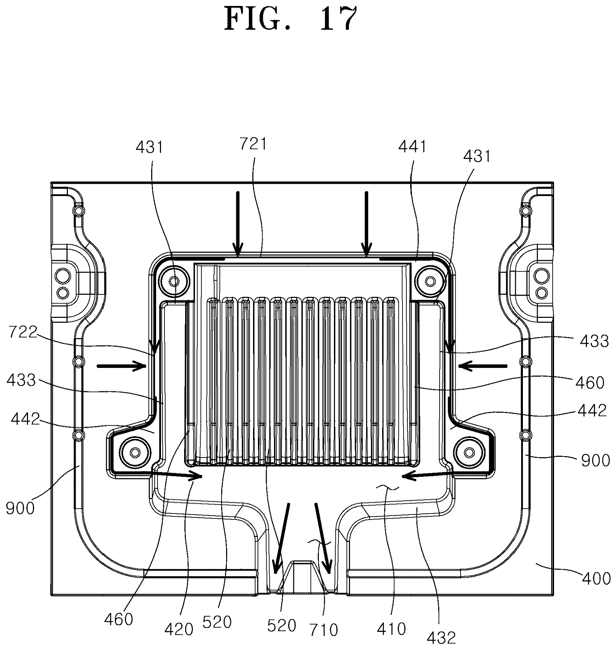

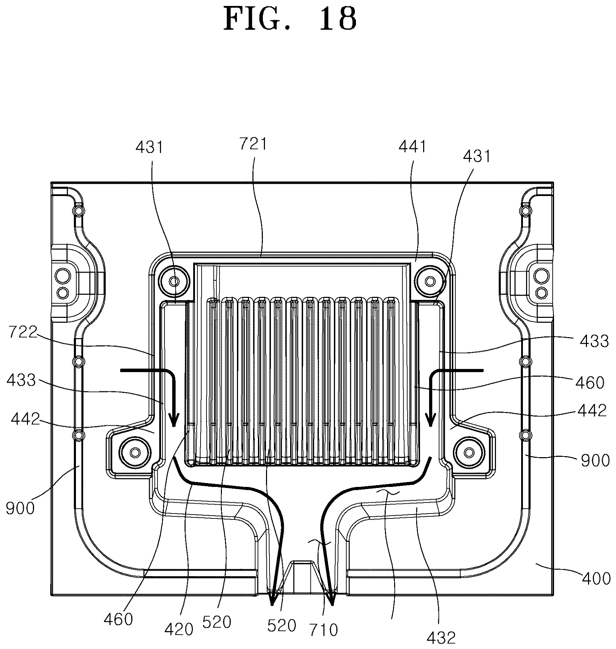

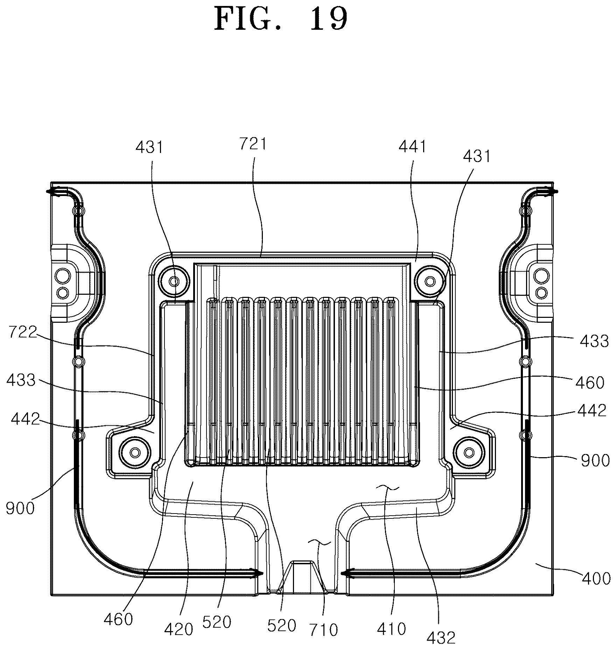

FIGS. 17 to 19 are diagrams schematically illustrating the water discharge operation of the electronic device according to an embodiment of the present disclosure.

Referring to FIGS. 1 to 19, a portion of water formed on the first cover 400 due to leakage from a pipe located outside the electronic device, condensation, or the like may be introduced between the second inner wall 450 of the first cover 400 and the peripheral surface of the second cover 600.

The water introduced between the second inner wall 450 and the peripheral surface of the second cover 600 may be transferred to the first transfer channel 721 or the second transfer channel 722.

The water transferred to the first transfer channel 721 or the second transfer channel 722 may flow toward an end of the second transfer channel 722 by capillary action.

Thereafter, the water may be discharged into the chamber 410 through the end of the second transfer channel 722 and may be accumulated on the bottom plate 420.

As the bottom plate 420 is inclined downward along the first direction, the water on the bottom plate 420 may flow in the first direction by gravity and may be discharged to the outside of the housing 100 through the discharge channel 710.

In the case where an excessive amount of water is transferred to the transfer channel 720, water may overflow from the transfer channel 720 and be introduced between the lower surface of the second cover 600 and the support surface 440.

As the surface roughness of the first support surface 441 is lower than that of the second support surface 442, water overflowing from the first transfer channel 721 may be transferred to the second transfer channel 722 rather than being introduced between the lower surface of the second cover 600 and the first support surface 441.

The water overflowing from the first transfer channel 721 may be discharged into the chamber 410 through the space between the lower surface of the second cover 600 and the second support surface 442, and may be accumulated on the bottom plate 420.

As the bottom plate 420 is formed to be inclined downward along the first direction, the water on the bottom plate 420 may flow in the first direction by gravity and may be discharged to the outside of the housing 100 through the discharge channel 710.

Another portion of the water formed on the first cover 400 may be introduced into the second drain channel 900 disposed on the first cover 400.

The water introduced into the second drain channel 900 may flow along the second drain channel 900 and may be discharged to the outside of the housing 100 or to the discharge channel 710 through the opposite ends of the second drain channel 900.

The present disclosure has been described with reference to embodiments shown in the accompanying drawings, but these are merely illustrative, and those skilled in the art will recognize that various modifications and equivalent embodiments can be made therefrom.

Therefore, the technical scope of the present disclosure should be defined by the following claims.

## Claims

1. An electronic device, comprising:
a housing;
a substrate disposed in the housing and configured to allow an electronic element to be mounted thereon;
a first cover disposed on the substrate and including a chamber;
a heat dissipation plate disposed at a lower side of the chamber and configured to contact the electronic element;
a second cover disposed at an upper side of the chamber and coupled to the first cover; and
a first drain channel connected to the chamber and configured to discharge water introduced between the first cover and the second cover.

2. The electronic device of claim 1,
wherein the first cover comprises:
a bottom plate disposed at the lower side of the chamber and connected to the heat dissipation plate;
a first inner wall extending upward from the bottom plate and disposed to enclose a perimeter of the chamber;
a support surface disposed on an upper side of the first inner wall 430 and configured to contact a lower surface of the second cover; and
a second inner wall extending upward from the support surface and disposed to face a peripheral surface of the second cover,
wherein the first drain channel comprises:
a discharge channel passing through the first inner wall and connected to the chamber; and
a transfer channel recessed from the support surface and connected to the chamber.

3. The electronic device of claim 2, wherein the transfer channel is disposed to face a space between the second inner wall and the peripheral surface of the second cover.

4. The electronic device of claim 2 or 3,
wherein the first inner wall comprises:
a first end wall;
a second end wall disposed to be spaced apart from the first end wall in a first direction; and
a pair of side walls disposed between the first end wall and the second end wall and arranged to face each other in a second direction intersecting the first direction, and
wherein the discharge channel passes through the second end wall in the first direction.

5. The electronic device of claim 4, wherein an upper surface of the bottom plate is formed to be inclined downward along the first direction.

6. The electronic device of claim 4 or 5, wherein a thickness of the bottom plate decreases along the first direction.

7. The electronic device of any one of claims 4 to 6,
wherein the support surface comprises:
a first support surface disposed on an upper side of the first end wall; and
a second support surface connected to the first support surface and disposed on an upper side of each of the pair of side walls,
wherein the transfer channel comprises:
a first transfer channel recessed from the first support surface; and
a second transfer channel extending from an end of the first transfer channel and recessed from the second support surface.

8. The electronic device of claim 7, wherein an end of the second transfer channel passes through the side wall and is connected to the chamber.

9. The electronic device of claim 7 or 8, further comprising:
a cooling fan coupled to the housing and configured to introduce external air of the housing into the housing; and
a convection hole passing through the first end wall in the first direction and disposed to face the cooling fan.

10. The electronic device of claim 9, wherein a surface roughness of the first support surface is lower than a surface roughness of the second support surface.

11. The electronic device of any one of claims 4 to 10, further comprising a pair of partition walls extending from the first end wall and disposed to face respective ones of the side walls in the second direction.

12. The electronic device of claim 11,
wherein each of the pair of partition walls includes a first end and a second end spaced apart from each other in the first direction,
wherein the first end of the partition wall is connected to the first end wall, and
wherein the second end of the partition wall is disposed to be spaced apart from the second end wall.

13. The electronic device of any one of claims 1 to 12, further comprising a plurality of heat dissipation fins extending from the heat dissipation plate toward the second cover and disposed in the chamber.

14. The electronic device of claim 13, further comprising a thermal conduction pad disposed between the heat dissipation fins and the second cover.

15. The electronic device of any one of claims 1 to 14, further comprising a second drain channel spaced apart from the chamber and recessed from an upper surface of the first cover.
